# EUROPÄISCHE PATENTANMELDUNG

(11) **EP 0 865 129 A2**
(43) Veröffentlichungstag der Anmeldung: **16.09.1998**
(21) Anmeldenummer: 98103423.4
(22) Anmeldetag: 27.02.1998
(51) Int. Cl.: H02B 1/30

(54) **Stationäres Gehäuse mit Wandelementen aus Kunststoff**

(30) Priorität: 12.03.1997 DE 19711980
(71) Anmelder: KRONE Aktiengesellschaft, 14167 Berlin (DE)
(72) Erfinder: Teichler, Heide, 10829 Berlin (DE); Benedetto, Adrian, 12103 Berlin (DE); Worch, Winfried, 13591 Berlin (DE)

(57) **Zusammenfassung**

Die Erfindung betrifft ein stationäres Gehäuse zur Aufnahme elektrischer Einrichtungen, insbesondere Kabelverzweigungseinrichtungen. Es umfaßt separat hergestellte Wandelemente aus Kunststoff, die formschlüssig vor Ort zusammengesetzt werden können, wobei ein formstabiles Gestell als Träger für die elektrischen Einrichtungen dient und von diesen Kunststoffteilen so umschlossen wird, daß sich auf den Seitenwänden und dem Gehäusedach Fügestellen ergeben.. Die Kunststoffteile sind gegebenenfalls durch entsprechende Profilierungen oder Eckverstärkungen weiter versteift und bestehen aus glasfaserverstärktem Polyester, Polypropylen oder Polyethylen mit entsprechender Farbgestaltung und UV-Beständigkeit. Ein derartiges Gehäuse kann von einer Person leicht in wenigen Minuten vor Ort montiert werden und bei Bedarf für Reparatur wieder demontiert werden.

## Beschreibung

Die Erfindung betrifft ein stationäres Gehäuse zur Aufnahme von elektrischen Einrichtungen, insbesondere Kabelverzweigungseinrichtungen.

Derartige Gehäuse werden häufig für die wetterfeste Unterbringung von Komponenten der Telekommunikations- und Datentechnik benutzt, wobei auf einem Sockel, aus dem die Kabel austreten ein Gestell angeordnet ist, welches der Halterung der vorgenannten Komponenten dient, zu denen dann Kabel hingeführt oder weggeführt werden.

Bekannt sind Freiluftgehäuse, bei denen der Sockel mit einem Sockelunterteil verbunden ist und beide zusammen einstückig ausgebildet sind, wobei häufig das Sockelunterteil in den Boden eingelassen ist. Dieses Sockelunterteil dient einerseits der mechanischen Stabilisierung des Freiluftgehäuses, als auch dem Schutz der aus dem Erdreich austretenden Kabel.

Um dem stetig wachsenden Informationsbedürfnis gerecht zu werden, ist es notwendig neue Fernmelde- und Datennetze zu installieren oder vorhandene Netze zu vergrößern. Gleichgültig welche Arten von Verkabelungstechnologien oder Funktechniken in der Telekommunikation realisiert werden, allen Techniken ist gemeinsam, daß vermehrt elektrische Komponenten aus den Zentralvermittlungsstellen oder fernmeldetechnischen Gebäuden dezentral in Siedlungen oder an außerörtlich gelegene Abzweigstellen ausgelagert werden müssen. Die Anmelderin hat selbst in anderen Anmeldungen bereits vorgeschlagen, vorhandene Gestelle auf derartigen Sockeln zu doppeln, durch Parallelanordnung ähnlicher üblicher Freiluftgehäuse bzw. aus Hohlprofilschienen neue Gehäusestrukturen zu bilden. Dabei handelt es sich um Metallteile, die selbst eine genügende Eigensteifigkeit haben und in beliebiger Folge der Umhausung der Gestelle dienen oder die Schienen selbst Teile der Gestelle für das Anflanschen der elektrischen Bauteile sind.

Ein weiteres Problem ist, daß die vermehrt aufzustellenden Kabelverzweigungseinrichtungen oder ähnlichen Verteilergehäusen oder Gehäuse für Funkstationen in vorhandenen Wohnsiedlungen das harmonische Gesamtbild nicht stören dürfen. Bisher übliche einheitsgraue Freiluftgehäuse werden dieser Forderung selten gerecht. Ein weiteres Problem darin, daR die metallenen oder aus Kunststoffteilen zusammengesetzten Freiluftgehäuse gemäß dem Stand der Technik nicht sehr servicefreundlich sind.

Von daher liegt der Erfindung das Problem zugrunde, stationäre Gehäuse der vorbeschriebenen Art so auszugestalten, daß sie servicefreundlich sind, sowohl was die Bedienung der elektrischen Bauteile anlangt, als auch eine schnelle und einfache Montage durch möglichst eine Person ermöglichen sollen. Ein weiteres Problem stellt sich durch die Anpassung der relativ großen stationären Gehäuse an die Wohnumfeldgestaltung.

Das Problem wird erfindungsgemäß gelöst durch die Merkmale der Ansprüche 1 und 16. Weiterbildungen der Erfindung sind in den Unteransprüchen erfaßt.

Die Erfindung geht von der Idee aus, daß Kunststoffteile wetterfest sind und in beliebigem gestalterischen Design und Farbkomponenten herstellbar sind. Zudem sind Kunststoffteile relativ leicht und können selbst bei großflächigen Teilen von 1 m x 1m und etwa 3 mm Wanddicke leicht von einer Person gehandhabt werden. Davon ausgehend wird vorgeschlagen, derartige stationäre Gehäuse aus separat vorgefertigten Wandelementen aus recyclefähigem Kunststoff zusammenzusetzen, die durch Formschluß zusammengehalten werden und gemeinsam ein formstabiles Gestell umschließen. Dieses Geste dient der Anbringung der elektrischen Bauteile, z.B. zur Kabelverzweigung oder Aufnahme von Relaisstationen und ähnlichem.

Idealerweise besteht das Gehäuse aus gleichartigen Frontwandteilen und Rückwandteilen, die zugleich als integrale Teile der Seitenwände und / oder der Dachteile eines derartigen Gehäuses, welches in der Regel quaderförmig ausgebildet ist, aufweisen. Zwei derartige Teile können um ein metallenes Gestell, das z.B. auf dem Sockel einer Kabelverzweigungseinrichtung angeordnet ist, umschließen, indem die Teile gegeneinander gedrückt werden und dabei nach dem Nut-Feder-Prinzip die Seitenteile der vorderen und hinteren Gehäusehälften ineinander einrasten. Diese Methode oder Bauweise des Fügens auf der Fläche hat sich bei Reisekoffern bestens bewährt und verleiht dem Gehäuse eine höhere Steifigkeit als Gehäusen, die an den Eckbereichen zusammengefügt sind.
Gegebenenfalls können die Fügenuten oder Fügestellen auch nach Art eines Labyrinthes ausgebildet sein, so daß ein Eindringen von Niederschlagswässern unmöglich ist. Sofern eine entsprechende Windbelastung oder sonstige mechanische Belastung zu befürchten ist, können die Fügestellen zusätzlich mit Rastnasen oder Rasteinrichtungen ausgebildet sein, so daß die Gehäusehälften sicher miteinander arretiert werden können.
Es ist möglich anstelle zweier identischer Bauteile, die leicht auseinanderrastbar sind, auch unterschiedliche Teile zu verwenden, insbesondere wenn sehr große stationäre Gehäuse anzuordnen sind. Dann bietet es sich an eines der Wandelemente, z.B. das Vorderteil mit einer verschließbaren Öffnung auszustatten und diese Öffnung selbst wiederum mit einer, aus einem Kunststoffteil bestehenden, Verschließplatte zu verschließen, wobei nach Art üblicher Türen Scharniere und Schwenkhebelverrieglungen Verwendung finden können. Auch der Einsatz von Schlössern oder ähnlichen Verschließeinrichtungen, wie sie für sich bekannt sind, ist dabei möglich.

Für eine Zentrierung auf dem Gestell können das Vorderteil und das Hinterteil ebenfalls mit Rastnasen oder Führungseinrichtungen versehen sein, die an komplementär ausgebildeten Elementen des Gestelles geführt und gehalten werden. Derartige Führungsteile oder Halterungsteile für das Geste sollen natürlich innenseitig auf dem Gehäuseteilen oder Wandelementen angebracht werden, damit eine Demontage des Gehäuses von außen keinesfalls und auch erst dann möglich wird, wenn die Verschließplatte geöffnet ist.

Derartige Gehäuse können mit einem einstückig ausgebildeten Gehäusedach versehen werden, welches seinerseits in die Gehäusehälften oder Wandelemente einschiebbar und gegebenenfalls mit Hilfe von Schrauben oder Nieten von der Innenseite der Wandelemente her befestigbar ist. Dabei ist das Gehäusedach erfindungsgemäß so gestaltet, daß die Fügestellen der Wandelemente bzw. der vorderen und hinteren Gehäusehälften durch entsprechende Vorsprünge am Dach überdeckt werden.

Ein gegebenenfalls hermetisch dichtes Kunststoffgehäuse einer derartigen Kabelverzweigungseinrichtung, insbesondere wenn der Boden und die Kabeleinlässe mit entsprechenden Kabeldichtungen, z.B. Kabeltüllen aus Kautschuk abgedichtet sind, entwickelt eine große Wärme, was je nach Witterung zu entsprechender Kondenswasserbildung am Dach des Gehäuses führen könnte.
Aus diesem Grunde ist vorgesehen, in das Dach einen Einsatz zu integrieren oder eine Tropfnase am Dach auszubilden, so daß auf jeden Fall außerhalb des Bereichs des Gestelles bzw. der auf dem Gestell angeordneten, elektronischen Bauteile das Kondenswasser abtropfen kann. Alternativ kann die Kondenswasserbildung durch entsprechende Ausbildung des Daches, z.B. eine Kaminwirkung durch eine nach außen gerichtete Öffnung erzeugend, vermieden werden. Eine weitere Möglichkeit besteht darin, das einmal gebildete Kondenswasser in einer Schale oder einem schwammartigen Einsatz aufzufangen und das Wasser von da aus nach außen zu führen oder sukzessive Kondenswasser als Luftfeuchtigkeit wieder abzugeben.

Zur weiteren Stabilisierung eines Wandelementes kann erfindungsgemäß vorgesehen sein, dieses einseitig zu profilieren. Dies kann in einer generellen makroartigen Wölbung der Bauteile bestehen oder auch in einer kleinteiligen Sickenbildung oder Rippenanordnung, vorzugsweise auf den Außenseiten des Gehäuses. Eine derartige stabilisierende Bauweise kann durch entsprechendes Design der Gehäuse kaschiert werden, wozu auch eine entsprechende Farbgebung behilflich sein kann.

Die Bodenplatte des Gehäuses ist vorzugsweise geteilt, so daß von beiden Seiten die Bodenhälften auf das Gestell zugeschoben werden können, bzw. entsprechende Kabeleinführungstüllen am Boden des Gehäuses umschlossen werden.

Als Kunststoff wird vorzugsweise ein glasfaserverstärkes Polyesthermaterial verwendet, welches als Laminat ausgebildet ist oder als einheitliches Preßteil (smc- sheet moulding compound), gegebenenfalls aus recycletem Material, hergestellt wird. Je nach Größe des Teiles kann es sich jedoch auch um ein Spritzgußteil handeln, welches aus modifizierten Polypropylen oder Polyethylen besteht, wodurch sich allerdings die Gewichte der Teile erhöhen, wenn die Eigensteifigkeit nicht ausreichend ist. Zu beachten ist dabei, daß entsprechende UV-Stabilisatoren in die Spritzgußmasse eingebracht werden, wie dies aber für sich aus dem Stand der Technik bekannt ist.

Aus Gründen der Wärmedämmung zur Minimierung von Schwitzwasser oder Schalldämmung zur Verhinderung von störenden Geräuschen können die Wandelemente auch mit einer Dämmung ausgekleidet werden, die vorzugsweise mit Klemmelementen an den Wandelementen befestigt werden, so daß demontierte Gehäuse leicht einem Recyclingverfahren zugeführt werden können. Eine Stofftrennung unterschiedlicher Kunststoffe voneinander kann so vermieden werden. Dasselbe gilt für gegebenenfalls vorzusehende Türdichtungen oder Fugendichtungen.

Um die Kunststoffgehäuse so leicht wie möglich ausbilden zu können, ist des weiteren vorgesehen, entweder stationäre steife Gestelle aus Blechrahmen oder ähnliches zu verwenden und in diese Zugentlastungsschienen einzuhängen, an denen mit entsprechenden Klammern oder Hängevorrichtungen einzuführende Kabel aufgehängt werden können. Die Belastung geht dann nur auf das Gestell und nicht auf die Gehäuseteile, so daß diese entsprechend leicht ausgebildet werden können.

Bei kleineren Gehäusen kann jedoch auch vorgesehen sein, daß das Gestell als integrales Teil eines Wandelementes ausgebildet ist oder daß die Wandelemente z.B. in ihren Ecken so versteift werden, daß dort Gestelle eingehängt werden oder Zugentlastungsschienen positioniert werden können.

Ein Freiluftgehäuse als Kabelverzweigungseinrichtung kann auf einem Sockel, wie er häufig vorhanden ist, so gestaltet sein, daß ein formstabiles Gestell aus Metall auf dem Sockel fixiert ist und aus einem Herstellerwerk nur die Gehäuseteile angeliefert werden, die dann als geteilte Bodenplatte, Hinterwand, Vorderwand, eingesetzter Tür, einem Dach und gegebenenfalls Dichtungen bestehen, in einer Vor-Ort- Montage das Freiluftgehäuse komplettieren.

Anhand einer Zeichnung soll die Erfindung näher erläutert werden.
Es zeigen:
- Figur 1: in einer Explosionsdarstellung ein komplettes erfindungsgemäßes Gehäuse mit separatem Gestell;
- Figur 2: ein erfindungsgemäßes Gehäuse ohne Verschließelement mit integriertem Gestell;
- Figur 3 a bis e: in vier Ansichten und einer perspektivischen Draufsicht ein geschlossenes Gehäuse gemäß Figur 1;
- Figur 4: eine Zugentlastungsschiene zur Integration in ein Wandelement oder ein Gestell;
- Figur 5: eine Zugentlastungsschiene in Seitenansicht.

In der folgenden Beschreibung haben gleiche oder identische Teile identische Bezugszeichen.

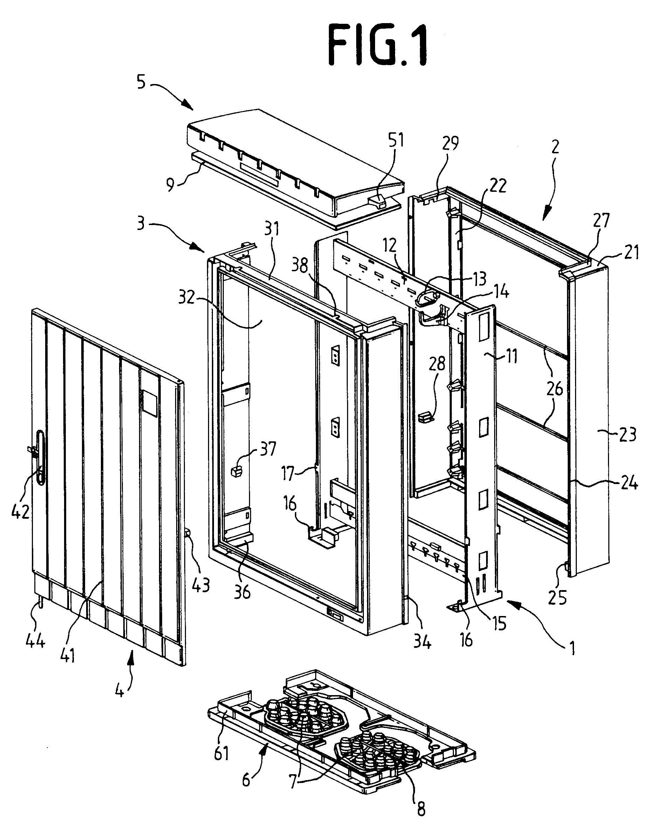

Figur 1 zeigt ein Blechgestell 1 mit Wangen 11 und als Querholme ausgebildeten Zugentlastungsschienen 15 und 12, an denen Kabel (nicht dargestellt) mit Kabelringen 13 oder Halterungen 14 zugentlastet aufgehängt werden können. Diese Gestelle haben innen seitlich Haltenasen bzw. Führungseinrichtungen 17 bzw. 16, die in komplementäre Führungseinrichtungen 37, 36 eines Gehäusevorderteiles 3 einrasten können bzw. dieses zentrieren. Das aus Kunststoff bestehende vordere Gehäuseteil 3 mit integraler Seitenwange 33 hat eine überlappende Fügestelle 34, die mit einer komplementär ausgestatteten Fügestelle, der Fügenut 24 an Seitenwange 23, in der ebenfalls aus Kunststoff bestehenden Gehäuserückteil 2 in Eingriff gebracht werden kann. Die beiden Kunststoffteile 2, 3 werden, in Gebrauchslage in der Explosivzeichnung dargestellt, spiegelsymmetrisch auf das Gestell 1 zugeschoben, ineinander gepaßt bis die Fügestellen 24 und 34 ineinander einrasten. Zugleich rasten die Haltenasen bzw. Führungseinrichtungen 36, 37 und 25 bzw. 28 in entsprechend komplementär gestaltete Teile des Gestelles 1 ein.
Am Querholm 31 des Vorderteiles 3 des Gehäuses und dem Querholm 21 des Rückteiles 2 des Gehäuses sind Fügestellen 38 und 27, 29 zu erkennen, die dem Einrasten des Daches 5, welches auf beide Gehäuseteile 2, 3 aufsetzbar ist, dienen. Die Querholme bilden zugleich integrale Teile des Gehäusedaches, so daß auch das Dach 5 nicht an den Eckbereichen mit den anderen Wandelementen 2, 3 seine Fügestelle hat, sondern auf der oberen Gehäusefläche. Nach Fixieren des Daches 5 überdeckt der Vorsprung 51 des Daches 5 die gekoppelten seitlichen Fügestellen 24, 34, so daß in diese Fügestellen von oben kein Wasser eindringen kann.
Eine Kondenswasserableiteinrichtung 9, angekoppelt an das Dach 5, komplettiert das Gehäuse von oben, während vorderseitig in die Öffnung 32 des Vorderteiles 3 eine Verschließplatte 4 eingesetzt werden kann. Diese Verschließplatte 4 kann mittels Scharnieren 43 in dem Gehäuseteil 3 gehaltert werden, während ein Griff 42 in Kombination mit einer Verschließeinrichtung 44 diese Platte in dem Vorderteil 3 arretiert. Die Vorderwand ist stark profiliert durch entsprechende Sicken 41, so daß der Verschließplatte 4 eine zusätzliche Steifigkeit verliehen wird und zugleich die große Fläche von ca. 1 m x 1 m optisch durch entsprechende Schattenbildung unterteilt wird.

Da das Gestell in der Regel auf einem Unterteil, von dem aus die Kabel in das Gehäuse gelangen, aufgesetzt ist, muß die Unterseite des Gehäuses von beiden Seiten her mit entsprechenden Bodenteilen 6 verschlossen werden, wobei sich Rippen 61 dichtend an die Gehäuseteile 2, 3 anlegen. In der Regel werden die Bodenplatten auch zuerst montiert, nach dem zuvor die Kabeldurchführungen 7 mit entsprechenden Kabeldichttüllen 8 aus Kautschuk um die Kabel gesetzt worden sind.

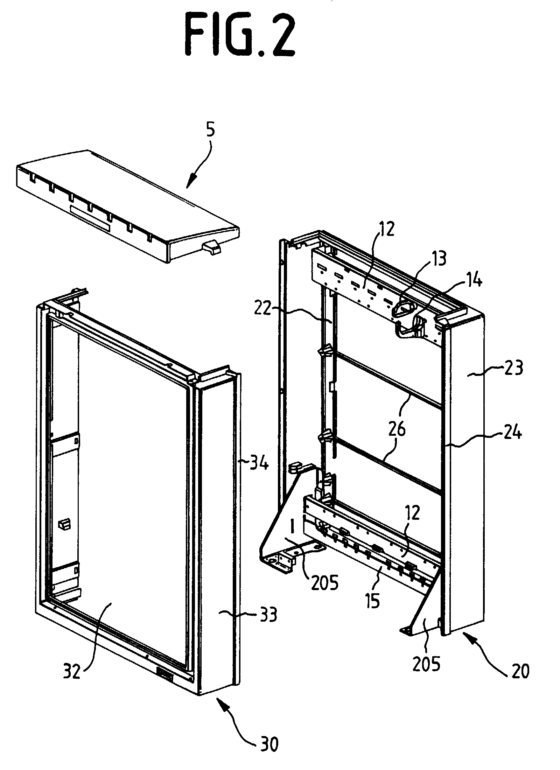

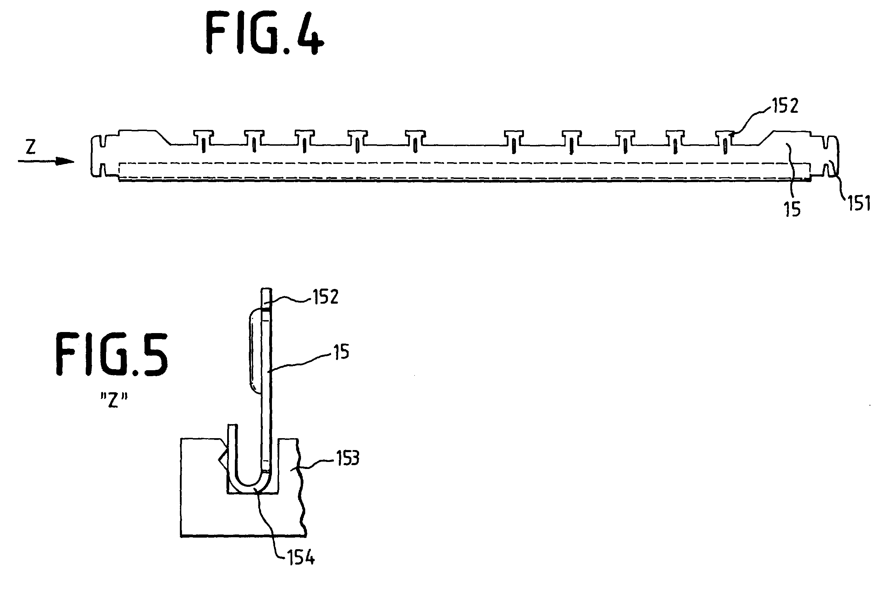

Figur 2 zeigt, daß das aus gleichförmigen Front- und Rückteilen 30 und 20 bestehende Gehäuse additiv oder alternativ auch mit Zugentlastungsschienen 12, 15 in einem der beiden Gehäuseteile, hier der rückwärtigen Gehäusehälfte 20 mit geschlossener Rückwand ausgestattet sein kann. In diesem Beispiel ist die Frontwand 30 offen, um von daher Montagearbeiten in der Rückwand auszuführen, könnte jedoch wie die Rückwand geschlossen sein. Eine solche Zugentlastungsschiene 15 der in Fig. 4, 5 dargestellten Bauart oder ähnlich ist in der Rückwand 20 angeordnet und in den verstärkten Eckbereichen 22 eingerastet. Durch Aussteifungen 26 und stabile Gestellteile 205 wird dieses einfache Gehäuse gebrauchsfest und noch leichter montierbar als die in Figur 1 beschriebenen.

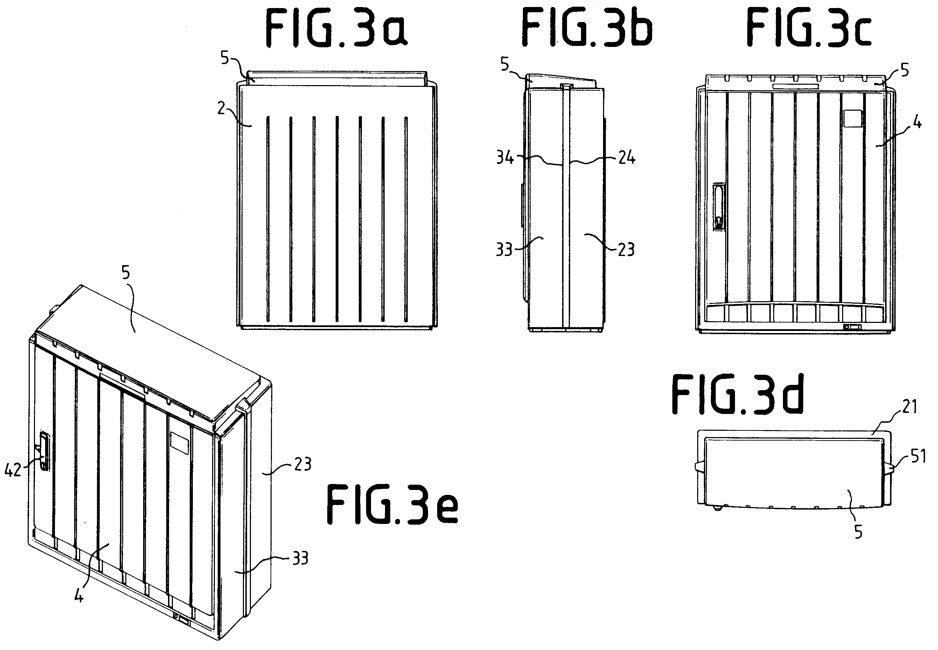

Figur 3 a zeigt das komplettierte Gehäuse von der Rückseite mit aufgesetztem Dach 5, während Figur 3 b eine Seitenansicht des Gehäuses mit den auf der Seitenwand des Gehäuses befindlichen Fügestellen 24, 34 zeigt.
Figur 3 c ist eine Frontalansicht der Verschließplatte 4 und des aufgesetzten Daches 5 des Gehäuses, während Figur 3 d eine Draufsicht auf das Dach 5 mit den zuvor beschriebenen Abdecknasen 51 zeigt. In Figur 3 e ist nochmals eine perspektivische Ansicht eines geschlossenes Gehäuses gemäß den Teilansichten 3 a bis 3 d dargestellt. Das Gehäuse ist aus glasfaserverstärktem Polyesther gefertigt worden, wobei die einzelnen Gehäuseteile in einer entsprechenden Presse im Herstellerwerk vorgeformt wurden und eine vom Auftraggeber bestimmbare Farbgestaltung erhalten haben.

Figur 4 zeigt in der Frontansicht eine Zugentlastungsschiene mit entsprechenden Entlastungshaken 152 für das Aufhängen von Kabeln mittels Kunststoffbindern. Die Zugentlastungsschiene 15 kann mittels Rastnasen 151 in das Gestell (Fig 1, 2) eingesetzt werden. Gemäß der Erfindung ist es jedoch ebenso möglich, diese Rastnasen in versteifte Ecken 22 eines Frontteiles, eines Rückteiles 2 oder einer Gehäusehälfte 20 einzusetzen.

Figur 5 zeigt eine Seitenansicht zu Fig. 4. Die Zugentlastungsschiene 15 mit dem hier - entgegen der auch umgekehrt nutzbaren Gebrauchslage - unten dargestellten Klemmbügel 154, kann auch mit entsprechenden Kabelschellen 153 kooperieren; die zugehörige Klemmschraube ist nicht dargestellt. Die Entlastungshaken 152 können zusätzlich benutzt werden.

### Bezugszeichenliste

- 1: Gestell
- 2: Gehäuseteil
- 3: Gehäuseteil
- 4: Verschließplatte
- 5: Dach
- 6: Bodenteil
- 7: Kabeldurchführung
- 8: Kabeldichttülle
- 9: Kondenswasserableiteinrichtung
- 11: Wange
- 12: Zugentlastungsschiene
- 13: Kabelring
- 14: Halterung
- 15: Zugentlastungsschiene
- 16: Führungseinrichtung
- 17: Haltenase
- 20: Gehäusehälfte
- 21: Querholm
- 22: Eckverstärkung
- 23: Seitenwange
- 24: Fügenut
- 25: Haltenase
- 26: Aussteifung
- 27: Fügestelle
- 28: Haltenase
- 29: Fügestelle
- 30: Gehäusehälfte
- 31: Querholm
- 32: Öffnung
- 33: Seitenwange
- 34: Fügestelle
- 36: Führungseinrichtung
- 37: Haltenase
- 38: Fügestelle
- 41: Sicke
- 42: Griff
- 43: Scharnier
- 44: Verschließeinrichtung
- 51: Abdecknase
- 61: Rippe
- 151: Rastnase
- 152: Entlastungshaken
- 153: Kabelschelle
- 154: Klemmbügel
- 205: Gestellteil

## Patentansprüche

1. Stationäres Gehäuse zur Aufnahme elektrischer Einrichtungen, insbesondere Kabelverzweigungseinrichtungen, umfassend separat hergestellte Wandelemente aus recyclefähigem, wetterfestem Kunststoff, die formschlüssig zusammengesetzt ein formstabiles Gestell (1, 11, 205) umschließen, wobei je ein Wandelement ein Frontteil (3, 30) und ein Rückteil (2, 20) sowie integral angeformte Teile zugleich die Seitenwände (23, 33) eines quaderförmigen Gehäuses bilden.

2. Gehäuse nach Anspruch 1, dadurch gekennzeichnet, daß das Frontteil und das Rückteil (2, 20) zugleich integral angeformte Teile (21) eines Gehäusedaches bilden.

3. Gehäuse nach Anspruch 1 oder 2, dadurch gekennzeichnet, daß die Wandelemente mindestens an den Rändern der integral angeformten Teile Fügestellen (24, 27, 29, 34) für eine überlappende Montage mit weiteren Wandelementen aufweisen.

4. Gehäuse nach einem der vorhergehenden Ansprüche, dadurch gekennzeichnet, daß die Fügestellen nach dem Labyrinth-Prinzip oder dem Nut-Feder-Prinzip gestaltet sind.

5. Gehäuse nach einem der vorhergehenden Ansprüche, dadurch gekennzeichnet, daß das Frontteil und das Rückteil gleichförmig ausgebildet sind.

6. Gehäuse nach einem der vorhergehenden Ansprüche, dadurch gekennzeichnet, daß das Wandelement mit einer großflächigen, verschließbaren Öffnung (32) versehen ist.

7. Gehäuse nach Anspruch 6, dadurch gekennzeichnet, daß die Öffnung mit einer innenseitig an dem Wandelement mittels Scharnieren (43) gehaltenen Verschließplatte (4) aus Kunststoff versehen ist.

8. Gehäuse nach einem der vorhergehenden Ansprüche, dadurch gekennzeichnet, daß ein Wandelement als einstückiges Gehäusedach (5) ausgebildet und auf den anderen Wandelementen (2, 3, 20, 30) befestigt ist.

9. Gehäuse nach Anspruch 8, dadurch gekennzeichnet, daß das Dach der Abdeckung (51) von Fügestellen dient.

10. Gehäuse nach Anspruch 8 oder 9, dadurch gekennzeichnet, daß das Dach Einrichtungen (9) zur Verhinderung des Abtropfens von Kondenswasser enthält.

11. Gehäuse nach einem der vorhergehenden Ansprüche, dadurch gekennzeichnet, daß das Wandelement mindestens einseitig profiliert (41) ist.

12. Gehäuse nach einem der vorhergehenden Ansprüche, dadurch gekennzeichnet, daß die Wandelemente innenseitig lösbar mit weiteren Kunststofformteilen zur Schall- und Wärmedämmung sowie zu Dichtzwecken verbunden sind.

13. Gehäuse nach Anspruch 12, dadurch gekennzeichnet, daß die Kunststofformteile mittels Klemmen mit den Wandelementen verbunden sind.

14. Gehäuse nach einem der vorhergehenden Ansprüche, dadurch gekennzeichnet, daß das Gestell Teil (205) eines Wandelementes (20) ist oder an versteiften Teilen (22) des Wandelementes befestigt ist.

15. Gehäuse nach einem der vorhergehenden Ansprüche, dadurch gekennzeichnet, daß eine Zugentlastung (12, 13, 14, 15) für in das Gehäuse geführte Kabel ausschließlich mit dem Gestell gekoppelt ist.

16. Freiluftgehäuse zur Aufnahme von elektrischen Bauteilen, bei dem ein formstabiles Gestell aus Metall (1) auf dem Sockel einer Kabelverzweigungseinrichtung fixiert ist und durch Wandelemente umfassend eine geteilte Bodenplatte (6), eine Rückwand (2,20), eine Frontwand (3, 30) mit Tür (4) und ein Dach (5), alle Teile aus Kunststoff vorgefertigt, in Vor-Ort-Montage umschließbar ist, wobei die Front- und die Rückwand zugleich mit integralen Teilen die Seitenwände (23, 33) bilden und dort ineinandergefügt sind.
